# EUROPEAN PATENT APPLICATION

(11) **EP 4 016 530 A1**
(43) Date of publication of application: **22.06.2022**
(21) Application number: 20315493.5
(22) Date of filing: 16.12.2020
(51) Int. Cl.: G11C 11/16, H01L 27/16, H01L 27/22, H01L 43/08, H01L 43/10

(54) **MAGNETO RESISTIVE MEMORY DEVICE WITH THERMALLY ASSISTED OPERATIONS**

(71) Applicant: Antaios, 38240 Meylan (FR)
(72) Inventor: Brun-Picard, Jérémy, 1950 Sion (CH); Drouard, Marc, 26000 Valence (FR); Martin, Sylvain, 38100 Grenoble (FR); Kula, Witold, Gilroy, CA 95020 (US)
(74) Representative: IP Trust

(57) **Abstract**

The invention relates to a magneto resistive memory cell (1) comprising a SOT current layer (3) defining a main plane; a magnetic tunnel junction (2) residing on the SOT current layer (3); and a first conductive line (4a) in electrical contact with the SOT current layer (3) at a first interface to flow a first current (I, I1, R) into at least a portion of the SOT current layer (3), along a first path. According to the invention, the first interface is a Peltier junction presenting a Peltier coefficient greater, in absolute value, than 30 mV to generate or absorb heat while the first current is flowing in the first path.

## Description

### FIELD OF THE INVENTION

The present invention relates to a magneto resistive memory device.

### BACKGROUND OF THE INVENTION

WO2012014131 and WO2012014132 disclose the structure of a memory cell of a so-called SOT magneto resistive memory device and the general architecture of an array of such cells. In the configuration proposed in those documents, a magnetic source external to the memory cell is provided for generating a magnetic bias field to allow deterministic switching of the cell during a write operation. In the magneto resistive memory cell disclosed in WO2012056348, this bias field is not necessary.

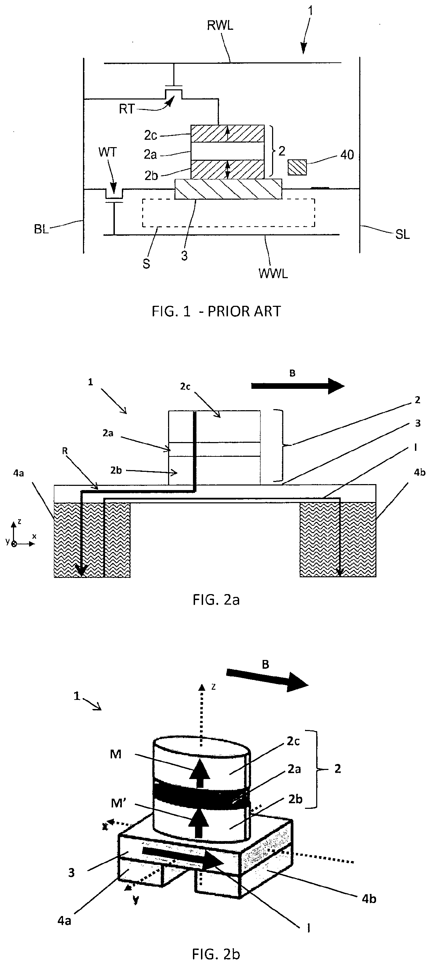

Figure 1 shows an example of a memory cell according to the general principle disclosed by these documents.

The memory cell 1 is disposed on a substrate S that defines a main plane. The memory cell 1 includes a magnetic tunnel junction structure 2 that includes a thin dielectric layer 2a sandwiched between a ferromagnetic free layer 2b and a ferromagnetic pinned layer 2c. The dielectric layer 2a forms a tunnel barrier layer between the pinned layer 2c and the free layer 2b. The orientation of the magnetization of the ferromagnetic pinned layer 2c is fixed, perpendicular to the substrate S main plane in this example. In other known configuration, the orientation of the magnetization may lie in the plane of the substrate S. The magnetization orientation of the free layer 2b is switchable in the perpendicular axis into one of a parallel state or an antiparallel state with respect to the magnetization orientation of the pinned layer 2b. The free layer may comprise material selected in the list constituted of Fe, Co, Ni, FeCo, CoNi, CoFeB, FeB, FePt, FePd or other suitable ferromagnetic material. The pinned layer 2c may comprise materials selected in the list constituted of Fe, Co, Ni, FeCo, CoNi, CoFeB, FeB, FePt, FePd or other suitable ferromagnetic material. Finally, the dielectric layer 2a may comprise MgO, Al2O3 or other suitable dielectric materials.

The resistance value between the pinned layer 2c and the free layer 2b is dependent on the actual state of the free layer magnetization orientation. When the free layer 2b and the pinned layer 2c have parallel magnetizations, the magnetic tunnel junction presents a relatively lower electric resistance, whereas in the antiparallel magnetizations the magnetic tunnel junction presents a relatively higher electric resistance. The switchable relative magnetization orientation of the free layer 2b defines therefore two states of the memory cell 1, to respectively represents the "0" and "1" values of a bit of information.

The memory cell of figure 1 also comprises a SOT current layer 3 disposed in the main plane of the substrate S, and on which resides the magnetic tunnel junction 1. The free layer 2b of the junction 1 is electrically coupled to the SOT current layer 3, for instance the free layer 2b may be in direct contact with a first face of the SOT current layer. The SOT current layer is made of conductive heavy metal layer such has Ta, W, Pt, Cu, Au or other suitable materials.

As described in the first two cited documents, the memory device also includes a magnetic source 4 providing a magnetic bias field extending to the magnetic tunnel junction 2. The magnetic bias field (whose amplitude is typically between 100 Oe to 1500 Oe) allows the deterministic switching of the free layer magnetization when a write current is flowing in the SOT current layer. It is important to control the amplitude and homogeneity of this field in the free layer, such that an intended state, "0" or "1", may be reliably be stored into a junction 2.

In a read operation, a signal from a read word line RWL, turns on a read transistor RT to flow a read current between a bit line BL and a source line SL through the magnetic tunnel junction 2. By sensing the read current, it is possible identify electric resistance of the magnetic tunnel junction, which is dependent on the relative orientation of the magnetization of the pinned layer 2c and of the free layer 2b as mentioned above, and hence of the state store in the memory cell.

In a write operation, a signal from a write word line WWL turns on a first write transistor WT to flow a write current between the bit line BL and the source line SL in a write path including the SOT current layer of the selected memory cell. The current flowing in the SOT current layer generates a spin-orbit torque that aim at changing the magnetization orientation of the free layer 2b. It is possible to write the magnetic tunnel junction 2 in one configuration by passing a current in one direction (for instance from the bit line BL to the source line SL) and by reversing the current direction (for instance from the source line SL to the bit line BL) it is possible to write the magnetic tunnel junction 2 in the other configuration.

### OBJECT OF THE INVENTION

The large-scale integration of such a SOT magneto resistive memory device requires improvements to the architecture proposed in the state of the art just outlined above. In general terms, the object of the present invention is to propose an alternative magneto resistive memory cell architecture. This alternative architecture provides a more reliable operation of the memory cell, for a given write or read current. It may also contribute to reducing the write current intensity and/or to improving the device operation range, for instance by reducing thermal fluctuation that may occurs as the device operates.

### SUMMARY OF THE INVENTION

To this effect, the invention relates to a magneto resistive memory cell comprising a SOT current layer defining a main plane and a magnetic tunnel junction residing on the SOT current layer. A first conductive line is in electrical contact with the SOT current layer at a first interface to flow at least a first current into at least a portion of the SOT current layer, along a first path.

According to the invention the first interface is a Peltier junction presenting a Peltier coefficient greater, in absolute value, than 30 mV to generate or absorb heat while the first current is flowing in the first path.

The amount of heat generated or absorbed at the first interface between the SOT current layer and the first conductive line is dependent at least on the nature of the materials forming these elements, the geometry of the first interface, the intensity and direction of the first current, and the duration of the current flow.

According to some embodiments, generation of heat may be provoked by a write current sufficient to store a first state into the magnetic tunnel junction, and the quantity of heat is sufficient in combination with the heat generated by Joule effect, to increase by conduction through the SOT current layer the temperature of the magnetic tunnel junction by a determined amount. At a relative higher temperature, the switching of the magnetization orientation of the free layer of the magnetic tunnel junction is made easier, and therefore the first state may be stored in the magnetic tunnel junction more reliably or with a first write current of less intensity than in the prior art where the interface is not particularly configured to generate heat.

In other embodiments, the write current for storing a first state into the magnetic tunnel junction is provoking absorption of heat, rather than generation. In these embodiments, the quantity of heat may compensate at least a portion of the heat generated by Joule effect while operating the memory cell or the heat provided by conduction by the environment surrounding the memory cell. This allows to limit the temperature elevation of the memory cell, and more generally of the memory device, which, if it exceeds a predetermined threshold, may results in performance degradation of the cell and of the device.

Similarly, according to some embodiments, absorption or generation of heat may be provoked by a read current. The quantity of heat absorbed may be compensating at least a part of the heat generated by Joule effect, and the temperature of the magnetic tunnel junction may be reduced compared to a memory cell of the state of the art. At this lower temperature, thermal fluctuation of the free layer magnetization orientation is reduced, and the state of the memory cell may be read with greater reliability. Alternatively, the generated heat may be sufficient in combination with the heat generated by Joule effect, to increase, by conduction through the SOT current layer, the temperature of the magnetic tunnel junction.

According to further non-limitative features of the invention, either taken alone or in any technically feasible combination:
- the first conductive line is made of a p-type or a n-type semi-conductor material;
- the first path comprises a first write path, the first write path comprising a second conductive line in electrical contact with the SOT current layer at a second interface to flow a first write current in the SOT current layer and store a first state in the magnetic tunnel junction;
- the first conductive line and the second conductive line are made of material presenting similar thermoelectric properties, and the magnetic tunnel junction is disposed on the SOT current layer closer to the first interface than to the second interface;
- the magneto resistive memory cell further comprises a third conductive line in electrical contact with the SOT current layer at a third interface to flow a second write current along a second write path comprising the third conductive line, the SOT current layer and the second conductive line to store a second state into the magnetic tunnel junction;
- the first conductive line and the second conductive line are respectively made of semi-conductor materials of opposite doping type;
- the magneto resistive memory cell further comprises a third and fourth conductive lines in electrical contact with the SOT current layer at respective third and fourth interfaces to flow a second write current along a second write path comprising the third conductive line, the SOT current layer and the fourth conductive line to store a second state into the magnetic tunnel junction;
- the magneto resistive memory cell further comprises a bias field oriented in the main plane such that it presents a component along the write current direction(s);
- the magneto resistive memory cell further comprises a MTJ conductive line disposed on the magnetic tunnel junction to flow a first write current through the magnetic tunnel junction while a first state is being written in the magnetic tunnel junction;
- the magneto resistive memory cell further comprises a third conductive line in electrical contact with the SOT current layer at a third interface to flow a second write current along a second write path comprising the MTJ conductive line, the magnetic tunnel junction and the SOT current layer to store a second state into the magnetic tunnel junction;
- the SOT current layer comprises a contact sub-layer in electrical contact with the first conductive line and a SOT sub-layer over the contact sub-layer;
- the first path comprises a first read path, the magneto resistive memory cell being further configured to flow a read current in the first read path comprising the magnetic tunnel junction and the first interface.

### FIGURES

Many other features and advantages of the present invention will become apparent from reading the following detailed description, when considered in conjunction with the accompanying drawings, in which:
- Figure 1 represents a SOT magneto resistive memory cell of the prior art;
- Figures 2a and 2b represent a magneto resistive memory cell according to a first embodiment;
- Figure 3 represents a magneto resistive memory cell according to a second embodiment;
- Figure 4 represents a magneto resistive memory cell according to a third embodiment;
- Figure 5 represents a magneto resistive memory cell according to a fourth embodiment;
- Figures 6 to 8 represent a magneto resistive memory cell according to a fifth embodiment;
- Figure 9 represents a magneto resistive memory cell according to a sixth embodiment.

### DETAILED DESCRIPTION OF SPECIFIC EMBODIMENTS OF THE INVENTION

To keep the representations simple, only the elements relevant to the description of the present invention have been included in the figures. A memory device taking profit of the proposed magneto resistive memory cell may comprise further elements not included into the figures. In particular, the memory device includes the conventional circuits configured to have write and read currents circulate into the memory cell according to selected directions, intensities, timings and durations, so that requested read and write operations are effectively performed.

### General description of the magneto resistive memory cell

With reference to the figures, a magneto resistive memory cell 1 according to various embodiments comprises a SOT current layer 3 defining a main plane extending along the x and y directions on these figures. The memory cell 1 also comprises a magnetic tunnel junction 2 residing on the SOT current layer 3. The magnetic tunnel junction 2 comprises, from the SOT current layer 3, a free layer 2b, a tunnel barrier layer 2a and a reference layer 2c. The free layer 2b and the reference layer 2c are made of ferromagnetic materials.

As described in the introduction of this document, the SOT current layer 3 is contacting the free layer 2b of the magnetic tunnel junction 2, such that a write current flowing into the SOT current layer 3 generates a spin-orbit torque. The spin orbit torque generated by passing the write current through the SOT current layer 3 is able to affect the magnetization orientation M' of the free layer 2b of the junction 2. The SOT current layer 3 can be in direct contact with the free layer 2b or, alternatively, a thin separating layer (for instance of MgO) can be provided between the current layer 3 and the ferromagnetic free layer 2b.

The orientation M of the magnetization of the ferromagnetic reference layer 2c is fixed, perpendicular to the main plane as represented in figure 2b or lying in this plane. The magnetization orientation of the free layer 2b is switchable into one of a parallel state or an antiparallel state with respect to the magnetization orientation of the reference layer 2c, defining the two states of the memory cell 1. Ferromagnetic free and reference layers 2b, 2c materials can comprise FePt, FePd, CoPt, or a rare earth/transition metal alloy, in particular GdCo, TdFeCo, or Co, Fe, CoFe, Ni, CoNi, CoFeB, FeB. Their thicknesses may extend between 0.5 nm and 10 nm and preferably between 0.9 and 3 nm. The magnetic tunnel junction 2 may present a cross-section of any shape, such as a circular, an elliptical (as shown in figure 2b), a square or a rectangular shape in a cross section along a (x,y) plane. Its dimension in the main plane (diameter, major axis, side or length) can typically range between 5nm and 1 micron, preferably between 30nm and 60nm.

The magnetic tunnel junction structure 2 also includes a thin dielectric layer 2a sandwiched between the ferromagnetic free layer 2b and the ferromagnetic reference layer 2c. The dielectric layer 2a forms a tunnel barrier layer between the reference layer 2c and the free layer 2b, and may be formed of, or comprise, MgO, Al2O3 or other suitable dielectric materials. Its thickness can range between 0.1 nm to 3 nm, preferably between 0.5 to 2nm.

The SOT current layer 3 is represented on figure 2b of rectangular shape, its width and length being sufficient to support entirely the junction 2, but other shapes are also possible.

The SOT current layer 3 has a thickness that ranges between 0.5 nm and 200 nm, more particularly between 0.5 nm and 100 nm, or less than 10 nm. Preferably, the SOT current layer 3 has thickness lying in the range 0.5 nm to 5 nm. Advantageously, the thickness of the SOT current layer 3 is selected to be thin, such as the write current density flowing into this layer is relatively higher than the write current density flowing in other conductive line of the write path. SOT current layer 3 is usually made of a conductive heavy metal, which can include Ta, Bi, Pt, W, Ir, Ru, Pd, Cu, Au, Bi, Hf, Se, Sb or of an alloy of these elements. The SOT current layer 3 may also be made of, or comprise, a topological insulator such as Bi2Se3, Bi2Te3, Sb2Te3 or Bi1-xSbx, Bi1.1SbO.9Te2S, WTe.

Optionally, the magnetic tunnel junction 2 may also comprise a capping layer disposed on and in contact with the reference layer 2c, for instance for helping in maintaining the magnetization of the reference layer 2c. The capping layer may present a thickness comprised between 1 nm and 200 nm, and preferably between 30 nm to 100 nm. The capping layer may be formed of antiferromagnetic material, such a PtMn or IrMn, or may consist in a more complex arrangement, such as a synthetic antiferromagnet (SAF) multilayer structure. Capping material may also be formed of hard mask material used during manufacturing of the memory device.

The magnetization M, M' of the reference layer 2c and of the free layer 2b may be oriented according to different magnetization configurations of the memory cell 1.

In a first configuration, called "transverse in-plane", the magnetization direction lies in the main plane, perpendicular to the direction of the write current I, and in this particular configuration the switching of magnetization of the free layer 2b and the storage of a given state into the memory cell 1, may be achieved deterministically without an additional magnetic bias field B or other symmetry breaking mechanism.

In a second configuration, called "longitudinal in-plane", the magnetization M, M' of the reference layer 2c and of the free layer 2b may lie in the main plane, parallel to the direction of the write current I. In this configuration, the effective writing and storage of a state into the memory cell, i.e. the switching of the magnetization direction M' of the free layer 2b, requires to break the symmetrical behavior of the system, to favor the switching of the polarization of the free layer 2b into a definite state depending on the direction of the write current. To break such a symmetry, an external magnet providing a bias field B having a component perpendicular to the main plane is usually provided. In the presence of such a bias magnetic field B, the magnetization M' of the free layer 2b can be deterministically switched by changing the write current direction.

In a third configuration, called "perpendicular out of plane" and illustrated on figure 2b, the magnetization direction of the free layer 2b and reference layer 2c are perpendicular to the main plane. This third configuration also require a bias field B having a component along the current flow direction to break the symmetrical behavior of the system and favor the deterministic switching of the polarization of the free layer.

Pursuing the general description of the various embodiments of the present description, a magneto resistive memory cell 1 according to the invention, also comprises conductive lines 4a, 4b, for instance made of a metal or of a doped semi-conductor material, electrically connecting the SOT current layer 3 and/or the magnetic tunnel junction 2 to other circuits of the memory device. Those conductive lines 4a, 4b, that can take the form of conductive vias as represented in the figures, allow to flow the write I and read currents R along paths including at least a portion of the SOT current layer 3 such that a given state may be stored into the memory cell 1 or read from the memory cell 1.

In the present description, a write path is defined as the specific collection of elements of the memory cell 1 (conductive lines, SOT current layer...) electrically connected together to allow a given write current to flow and a given state to be stored into the memory cell 1. In some embodiment, a single write path is used to store a first state and a second state into the memory cell 1, by flowing respectively a first and a second write current along opposite directions of the single write path. In other embodiment, two distinct write paths are used to respectively store the first and second state into the memory cell 1, by flowing respectively the first write current along the first write path and a second write current along the second write path. In some embodiments, the conductive lines of a write path are of the same nature, i.e. made of the same material and, in case of a semiconductor, of the same doping type, n or p. More generally, the conductive lines may be made of materials presenting similar thermoelectric properties, such that currents crossing along the same direction the interfaces of the respective conductive lines with the SOT current layer will produce the same thermal effect, absorbing or generating heat. In other embodiments, the conductive lines of a write path may be formed of different materials, or of the same semiconductor but of opposite doping types. The different materials may be chosen such that they exhibit opposite thermoelectric properties. In other possible embodiments, some of the conductive lines may be made of material that do not present significant thermoelectric properties, when in contact with the SOT layer, apart from the Joule effect. In particular, the Peltier junction at that interface may present a Peltier coefficient lesser, in absolute value, than 30 mV.

Similarly, a read path is defined as the specific collection of elements of the memory cell 1 (conductive lines, the magnetic tunnel junction, a portion of the SOT current layer...) electrically connected together to allow a given read current to flow and sense the state stored into the memory cell 1.

When a conductive line is made of a semi-conductor material, it may comprise one or more material selected from the list formed of Bi2Te3, Bi2Se3, Sb2Te3, silicon carbide, gallium arsenide, gallium phosphide, indium phosphide, indium arsenide, indium antimonide, an alloy semiconductor such as SiGe, GaAsP, AlInAs, AlGaAs, GaInAs, GaInP, and/or GaInAsP, a 2D material such as graphene, WSe2, WeSe2.

When a conductive line is a metal, it may comprise one or more material selected from the listed formed of Cu, Al, Ag, Au, Pt, Co, Ni, Fe, Ta, W, Mo, Ti, Bi, Se, Mg, Sr, Ba, Pb, Te, Nb, Sn, As, Hf, Zr, V, Nb, In, their alloys.

More generally, a conductive line may be formed of any suitable thermoelectric material.

Hence, a memory cell 1 according to the invention comprises at least a first interface, i.e. a contact surface, between a first conductive line 4a and the SOT current layer 3. To store (or read) a first state into the magnetic tunnel junction 2, a first write current (or read current) is flowing into a first write path (or read path) including the first conductive line 4a and the SOT current layer 3. According to the invention also, the first interface is forming a Peltier junction presenting an absolute Peltier coefficient (at room temperature) greater than 30 mV to generate or absorb a significant amount of heat while the first write or read current is flowing in the first write or read path.

The materials forming the first conductive line 4a and the SOT current layer 3 are selected such that their junction presents a Peltier coefficient, in absolute value, greater than 30 mV, at room temperature.. This choice may be based on the absolute or relative Seebeck coefficient of the two materials involved, knowing that the Peltier coefficient is equal to the difference of the materials Seebeck coefficients multiplied by the temperature, that can be chosen as a room temperature of 300K.

The exact amount of heat generated or absorbed at the first interface between the SOT current layer and the first conductive line is dependent at least on the nature of the materials forming these elements, the geometry of the interface, the direction and intensity of the first current, and the duration of the current flow. All things being otherwise equal, the change of the first current direction across the interface will define whether the junction is generating or absorbing heat.

In some embodiments, the generation of heat may be provoked by a write current sufficient to store a first state into the magnetic tunnel junction, and the quantity of generated heat is advantageously sufficient, in combination with the heat generated by Joule effect, to increase by conduction through the SOT current layer, the temperature of the magnetic tunnel junction 2, and more specifically of the free layer 2b, by a determined amount, of 20°C or more, advantageously of 30°C or more, when compared to a conventional memory cell. At this relative higher temperature, the switching of the magnetization orientation M' of the free layer 2b of the magnetic tunnel junction is made significantly easier, and therefore the first state may be stored in the magnetic tunnel junction 2 more reliably or with a first write current of less intensity and/or duration.

It is not necessary that the complete magnetic tunnel junction 2 or even that the complete free layer 2b increases in temperature, and the enhanced performance of the memory cell 1 may be observed only if a portion of the free layer 2b increases in temperature by a determined amount while the current is flowing.

In other embodiments, the write current for storing a first state into the magnetic tunnel junction is provoking absorption of heat, rather than generation. In these embodiments, the quantity of heat may compensate at least a portion of the heat generated by Joule effect while operating the memory cell or the heat provided by conduction by the environment surrounding the memory cell. This allows to limit the temperature elevation of the memory cell, and more generally of the memory device, which, if it exceeds a predetermined threshold, may results in performance degradation of the cell and of the device.

Similarly, according to some embodiments, absorption or generation of heat may be provoked by a read current. The quantity of heat absorbed may be compensating at least a part of the heat generated by Joule effect, and the temperature of the magnetic tunnel junction may be reduced compared to a memory cell of the state of the art. At this lower temperature, thermal fluctuation of the free layer magnetization orientation is reduced, and the state of the memory cell may be read with greater reliability. Alternatively, the generated heat may be sufficient in combination with the heat generated by Joule effect, to increase by conduction through the SOT current layer the temperature of the magnetic tunnel junction, when compared to a memory cell of the state of the art.

The invention aims at taking advantage of these principles which can be implemented according to many different embodiments, which are the subject of the remaining parts of this description. Some embodiments of the memory cell 1 may be configured to only take advantage of the ability to absorb or to generate heat at the interface during a write operation. Other embodiments may be configured to only take advantage of the ability to generate or absorb heat during a read operation. It is not necessary that an embodiment of the invention is taking profit of both the generation or absorption of heat during a write and a read operation, although some embodiments may be able to do so.

For the simplicity of the explanation, the following description is relating to embodiments directed to a memory cell for which it is either desired to heat the magnetic junction while writing into the memory cell and/or desired to cool the magnetic junction while reading the memory cell. But, as it has been mentioned above, alternative operation of the memory cell according to which it is either desired to cool the magnetic junction while writing into the memory cell and/or desired to heat the magnetic junction while reading the memory cell, is also within the reach of the present invention.

### Embodiment 1

The first embodiment represented on figure 2a and 2b comprises a memory cell 1 that may be configured indifferently according to the transverse, longitudinal in-plane or perpendicular out of plane configuration recalled above. In addition to the first conductive line 4a, the SOT current layer 3 is also connected at a second interface to a second conductive line 4b, disposed on an opposite side of the SOT current layer 3, with respect to the magnetic tunnel junction 2. In this embodiment, the materials making the first conductive lines 4a and the second conductive line 4b are the same, i.e. the same metal for instance or the same semiconductor of a given type.

The memory cell 1 of this first embodiment presents a single write path including the first conductive line 4a, the SOT current layer 3, and the second conductive line 4b. To write a first state into the memory cell 1, a first write current I of sufficient intensity and duration is circulating along the write path from the first conductive line 4a, into the SOT current layer 3 and to the second conductive line 4b. The conductive lines 4a, 4b being made of the same material, by convention heat is generated at the first interface by Peltier effect, and heat is absorbed at the second interface. The generated/absorbed heat provokes a thermal transfer in the material separating the two interfaces, in particular by conduction in the SOT layer 3 and in the magnetic tunnel junction 2. Consequently, a temperature gradient is appearing longitudinally across the SOT layer 3 and the magnetic tunnel junction, from the first interface to the second interface. The temperature of the magnetic tunnel junction 2 closer to the first interface is therefore increasing as the first write current I is flowing along the first write path. As mentioned above, the increased temperature of this part of the magnetic tunnel junction 2, in particular when the temperature of the free layer 2b increases by an amount of at least 20°C, ease the switching of its magnetization direction M', compared by a convention memory cell. It is not necessary that the complete magnetic tunnel junction 2 or the complete free layer 2b increases in temperature.

To write a second state into the memory cell 1, a second write current of sufficient intensity and duration is circulating along the same write path, but in an opposite direction, from the second conductive line 4b to the first conductive line 4a. A similar phenomenon appears, this time heat being generated at the second interface and absorbed at the first interface. The temperature gradient appears longitudinally across the SOT layer 3 and the magnetic tunnel junction, increasing from the second interface to the first interface. The temperature of the magnetic tunnel junction 2 closer to the second interface is therefore increasing as the second write current is flowing along the first write path, and the switching of the magnetization direction M of the free layer is also facilitated.

To read the state stored into the memory cell 1, a read current R is flown into a first read path across the reference layer 2c, the tunnel barrier 2a and the free layer 2b of the magnetic junction, through a portion of the SOT layer and into the first conductive line 4a. This read path is including the Peltier junction formed at the first interface between the SOT layer 3 and the conductive line 4a, i.e the interface that is configured to generate heat when the first write current is crossing the junction to write the first state into the memory cell 1. When the read current is flowing from the magnetic junction 2 to the conductive line, in a reverse direction compared with the first write current, heat is absorbed at the first interface. Consequently, by thermal transfer, the temperature of the magnetic junction 2 is reduced compared to a memory cell 1 that would not be configured to exhibit significant Peltier effect at this first interface.

It is to be noted that the same effect would have occurred if the read current would have been flown in an alternative read path including the second interface, and therefore this embodiment is compatible with a read path including either the first interface or the second interface.

The memory cell 1 according to this embodiment is particularly simple to implement. Since the materials composing the conductive lines 4a, 4b are identical, the manufacturing of the memory cell 1 is not complex. Because of the symmetrical behavior, the temperature elevation of a part of the magnetic tunnel junction 2, and the benefit of such a temperature increase, occurs upon storing either states in this junction 2. These benefits may be however limited since only a part of the magnetic tunnel junction 2 experiences a temperature elevation during a write cycle of the first and second state. Also, the temperature of the magnetic tunnel junction 2 is better controlled during a read cycle, and the reliability in sensing the magnetization direction of the free layer 2a is improved, since thermal fluctuation is reduced.

In a variation of this embodiment, the material of the second conductive line 4b can be selected such that the second interface constitutes a junction presenting a Peltier coefficient lesser, in absolute value, than 30 mV. In this case, a read current flowing in the alternative read path including the second interface would not significantly generate or absorb heat.

### Embodiment 2

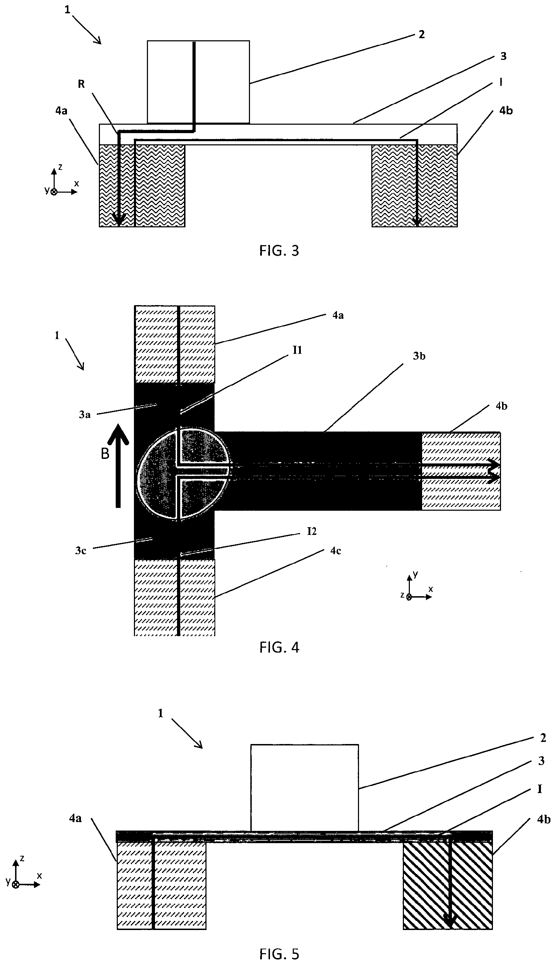

The second embodiment of figure 3 forms a variation of the first embodiment, and all the characteristics described in relation to the first embodiment also applies to this second embodiment unless stated otherwise. In the second embodiment, the magnetic tunnel junction 2 is disposed on the SOT current layer 3 closer to the first interface than to the second interface. Consequently, when a first write current I is flowing in the write path to write the first state into the memory cell 1, a larger part of the magnetic tunnel junction 2, and of the free layer 2b, is experiencing a temperature increase. Possibly, and depending on the relative position of the magnetic tunnel junction with respect to the first and second interface, all of the junction 2 may experience a temperature increase. Consequently, the switching of the magnetization direction of the free layer 2b into this first state is made easier and more reliable than in the first embodiment. For instance, it may require a first write current of less intensity or of less duration.

Conversely, when it is desired to store the second state into the memory cell, by flowing a second write current into the write path from the second conductive line 4b to the first conductive line 4a, the magnetic tunnel junction 2, and the free layer 2b, is experiencing a temperature variation that is not as favorable as in the first embodiment. This may be compensated by having the second write current of higher intensity or of longer duration, when compared with the second write current of the first embodiment. Alternatively, this effect may not be compensated, and the memory cell will on average operate at a lower temperature, assuming equivalent writing cycles of the first and second states, and a significative reading cycle of the cell.

The read operation of the second embodiment of figure 3 is identical to the read operation in the first embodiment, and this operation is performed with improved reliability.

### Embodiment 3

This embodiment aims at solving at least part of the limitations of embodiments 1 and 2 by providing separate write paths for storing the respective states in the memory cell 1. An example of this third embodiment is represented on figure 4.

Just as in the previous embodiments, a first write path I1, to store a first state in the memory cell 1, is extending from a first conductive line 4a to a second conductive line 4b via the SOT current layer 3. The first interface between the first conductive line 4a and the SOT current layer 3 is forming a Peltier junction configured to generate significant amount of heat while the first write current I1 is flowing in the first write path, as it has been explained previously. In this third embodiment however, the SOT current layer 3 is shaped such that the write path is not straight lined. The SOT current layer 3 is therefore comprising a first branch 3a to which the first conductive line 4a is connected, and a second branch 3b angled with the first branch 3a and to which the second conducive line 4b is connected. The first and second branch 3a, 3b are electrically connected together such that the first write current I1 can flow from the first conductive line 4a to the second conductive line 4b.

The memory cell of this embodiment also comprises a third conductive line 4c, connected to a third branch 3c of the SOT layer 3. The third branch 3c is also angled with and electrically connected to the second branch 3b of the SOT current layer, such that a second write current I2 may flow along a second write path including the third conductive line 4c, the third and second branch 3c, 3b of the SOT layer 3 and the second conductive line 4b. This second write current I2 and second write path allow to store a second state into the memory cell 1. The third interface between the third conductive line 4c and the SOT layer 3 is forming a Peltier junction configured to generate significant amount of heat just like the first interface.

In the example of the third embodiment represented on the figure 4, the first branch 3a and the third branch 3c of the SOT current layer 3 are aligned, and the second branch 3b is perpendicular to both the first and third branches 3a, 3c, although differing configurations are possible. In all cases however, the three branches 3a, 3b, 3c are connected to each other at central portion of the SOT current layer 3, and the magnetic tunnel junction 2 resides on the central portion of the SOT current layer 3. The first and second write currents I1, I2 may therefore circulate in different directions in the SOT current layer 3, under at least a portion of the magnetic tunnel junction 3 so that the magnetization of the free layer 2b can effectively be oriented according to one state or to the other.

The length of the second branch 3b of the SOT current layer 3, between the second interface to the magnetic tunnel junction is greater than the lengths of the first and third branches 3a, 3c, respectively between the first interface to the magnetic tunnel junction 2 and between the third interface to the magnetic tunnel junction 2. The materials forming the three conductive lines 4a, 4b, 4c of this embodiment are identical.

Because the first and second write currents are changing directions in the central portion of the SOT current layer 3, underneath the magnetic tunnel junction 2, this embodiment is more suited to a memory cell 1 configured according to a perpendicular out of plane configuration. The required bias field B may be oriented in the main plane (x,y) of the memory cell such that it presents at least a component along the y direction of the write currents flowing in the first, second 3a, 3b of the SOT current layer 3. Said differently, the bias field B is oriented in the main plane such that it is not perpendicular to any of the write currents I1, I2 flowing in the first and second branches. In such orientations, the symmetrical behavior of the system is efficiently broken and the deterministic switching of the polarization of the free layer 2b is achieved when the first and second write currents respectively flow along the first and second write paths.

In operation, the memory cell of this third embodiment is similar to the operation of the second embodiment: when the first write current I1, or respectively the second write current 12, is circulating in the SOT current layer 3, heat is generated at the first interface, respectively at the third interface. In both cases, heat is absorbed at the second interface. Since the magnetic tunnel junction 2 is closer to the first and third interface than it is to the second, the magnetic tunnel junction 2 is experiencing an overall temperature increase, preferably higher than 20°C, when compared to a conventional memory cell. Consequently, the switching of the magnetization direction of the free layer 2b into either state is made easier and more reliable than in the first embodiment. For instance, it may require a first write current of less intensity or of less duration. Since the switching in one state or the other is achieved by flowing a write current along different writing paths, the magnetic tunnel junction temperature can be increased in each situation, and the limitation of the second embodiment is overcome.

If it is desired to take advantage of the ability to absorb heat at the interface during a read operation of a memory cell according to this third embodiment, a read path may be configured to include the magnetic junction, a portion of the SOT layer and any of the first, second and third conductive lines 4a, 4b, 4c. Preferably, the read path is configured to include one (or both) of the first and third conductive lines 4a, 4c so that heat absorption is closer to the magnetic tunnel junction 2. If two conductive lines are in the same heat configuration it is possible to use both in the read path, to reduce the resistance of the read path. The read operation in this embodiment is then performed, just as in the two prior embodiments, such that the read current is flowing in the reverse direction than the first write and second write currents I1, I2 across, respectively, the first and third interfaces. The read current may cross the second interface in the same direction than the first and second write current, if this less favorable configuration is chosen.

### Embodiment 4

The fourth embodiment forms a variation to the first embodiment, and all the characteristics described in relation to the first embodiment also applies to this fourth embodiment unless stated explicitly otherwise. An example of this fourth embodiment is represented on figure 5. It presents a single write path including the first conductive via 4a, the SOT current layer 3 and the second conductive via 4b.

In this embodiment, the second interface between the SOT current layer 3 and the second conductive line 4b is also a Peltier junction configured to generate heat while the first write current is flowing in the write path.

To achieve this, the first conductive line 4a and second conductive line 4b are made of materials that differ in nature. For instance, the first conductive line 4a and the second conductive line 4b are made semi-conductor material of opposite types. As represented in figure 5, the first conductive line 4a is n type, doped with an electron donor element, and the second conductive line 4b is p type, doped with an electron acceptor element. The semiconductor materials of the first and second conductive line 4a 4b may be the same or different, for instance selected in the list provided earlier in this description.

When a first write current I is circulating in the single write path of the memory cell 1 according to this fourth embodiment, to store a first state heat is generated at both the first and second interface. Therefore, the diffusion of the generated heat by conduction in the material surrounding those interfaces tends to increase the temperature of both the SOT current layers 3 and of the magnetic tunnel junction 2, in particular of the free layer 2b of this junction 2. Therefore, the diffusion of the generated heat by conduction in the material surrounding those interfaces tends to increase the temperature of both the SOT current layers 3 and of the magnetic tunnel junction 2, in particular of the free layer 2b of this junction 2

When a second write current is circulating in the single write path of the memory cell in a direction opposite to the first write current I along that path, to store a second state different to the first one, heat is absorbed at both the first and second interface. The increase of the magnetic tunnel junction temperature may not be observed in this case, and this may be compensated by having the second write current of higher intensity or of longer duration, when compared with the second write current of the first embodiment.

Although a memory cell according to this embodiment may require additional manufacturing steps to be able to form the conductive lines in different materials, the free layer 2b is more effectively heated, during a write cycle of the first state. The switching of the magnetization direction of the free layer 2b into the first is made easier and more reliable than in the previous embodiments. For instance, it may require a first write current of less intensity or of less duration.

If it is desired to take advantage of the ability to absorb heat at an interface during a read operation of a memory cell according to this fourth embodiment, a read path may be configured to include the magnetic junction, a portion of the SOT layer and one of the first and second conductive lines 4a, 4b. The read operation is then performed such that the read current is flowing in the reverse direction compared to the first write current across the first interface when the read path includes the first conductive line 4a, or such that the read current is flowing in the reverse direction compared to the second write current across the second interface when the read path includes the second conductive line 4b.

### Embodiment 5

Embodiment 5 combines the features of the fourth embodiment (an improved elevated temperature by using different materials in the conductive lines) and of the third embodiment (separate write paths to store the two states of the memory cell 1).

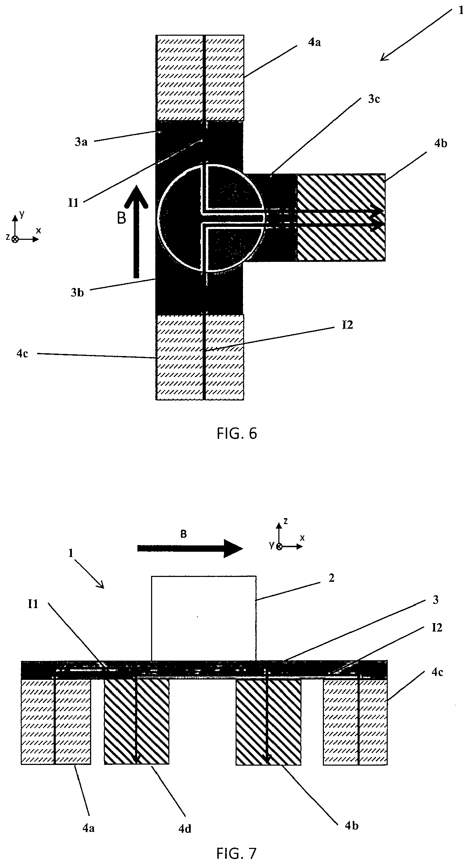

On the example represented on figure 6, the SOT current layer 3 is made of three distinct branches 3a, 3b, 3c as fully described in the third embodiment and not repeated here for the sake of brevity. In this fifth embodiment however, it is not necessary that the second branch 3b to be longer than the first and third branch 3a, 3c. The memory cell 1 may then be made more compact than the memory cell of the third embodiment.

The first and third conductive lines 4a, 4c may be made of the same material, such that the first interface (between the first conductive line 4a and the first branch 3a) forms a Peltier junction configured to generate heat while the first write current is flowing in the first write path I1, and such that the third interface (between the third conductive line 4c and the third branch 3c) forms a Peltier junction also configured to generate heat while the second write current I2 is flowing in the second write path.

The second conductive line 4b is made of a material that differs in nature from the first and second conductive lines 4a, 4c. For instance, the first and third conductive lines 4a, 4c, on one hand, and the second conductive line 4b, on the other hand, are made of semi-conductor materials of opposite doping types. On the figure, the first and third conductive lines 4a, 4c are n type, doped with an electron donor element, and the second conductive line 4b is p type, doped with an electron acceptor element.

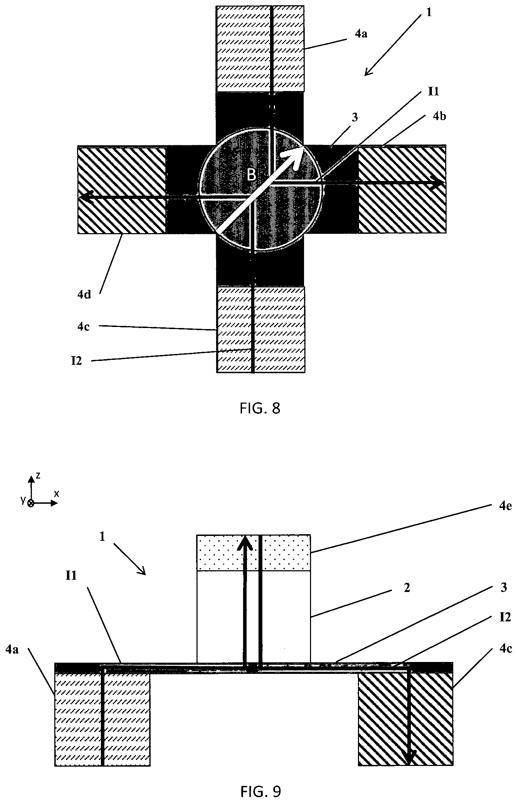

On the examples of the fifth embodiment represented on figures 7 and 8, the first and the second conductive lines 4a, 4b are in electrical contact with the SOT current layer 3 at respective first and second interfaces. A first write current I1 flowing along the first write path comprising the SOT current layer, the first and second conductive line 4a, 4b allows to store a first state into the magnetic tunnel junction 2a.

In addition, a third and a fourth conductive lines 4c, 4d are in electrical contact with the SOT current layer 3 at respective third and fourth interfaces. A second write current I2 flowing along a second write path comprising the SOT current layer 3, the third and fourth conductive lines 4c, 4d to store a second state into the magnetic tunnel junction 2.

Just like in the fourth embodiment, the first and second interfaces are Peltier junctions configured to generate heat while the first write current I1 is flowing in the second write path. Similarly, the third and fourth interfaces are Peltier junctions configured to generate heat while the second write I2 current is flowing in the second write path.

In the example represented on figure 7, the four conductive lines are all aligned, the first conductive line 4a and the fourth conductive line 4d being on one side of the magnetic tunnel junction 2, and the second conductive line 4b and the third conductive line 4c on the other side of the junction 2. The memory cell 1 of this example may be configured indifferently according to the transverse, longitudinal in-plane or perpendicular out of plane configuration. As already mentioned, in the transverse in-plane configuration, the bias field B is not necessary.

In the example of this embodiment represented on figure 8, the SOT current line is configured in a cross like pattern, comprising four branches electrically connected at a central portion, and the magnetic tunnel junction 2 resides on the central portion of the SOT current layer 3. The first and second write currents I1, I2 are changing directions in the central portion of the SOT current layer 3, respectively toward the second conductive line 4b and the fourth conductive line 4d that are disposed on separate opposite branches of the cross like SOT current layer 3. The memory cell 1 of this example is preferably configured according to a perpendicular out of plane configuration. To favor deterministic switching, the bias field B is oriented in the main plane such that it is not perpendicular to any of the write currents flowing in the different branches.

Similarly to the previous embodiments, it is possible to take advantage of the ability to absorb heat at an interface during a read operation of a memory cell according to this fifth embodiment. This is achieved by configuring a read path including one of the conductive lines, and selecting the read current such that its direction is opposite to the write current direction at the level of the interface with the selected conductive line.

### Embodiment 6

The sixth embodiment comprises a memory cell 1 that may be configured indifferently according to the transverse, longitudinal in-plane or perpendicular out of plane configuration. An example of a memory cell according to this embodiment is presented on figure 9. In this embodiment, the memory cell 1 combines the SOT approach to write a state in the magnetic junction by flowing a current in a SOT current layer onto which the magnetic junction resides, with the STT approach (Spin Transfer Torque) that flows a current, in one direction or the other, through the magnetic tunnel junction to switch the free layer 2b magnetization direction.

This memory cell 1 comprises a first conductive line in electrical contact with the SOT current layer 3 at a first interface to flow a first write current I1 into the SOT current layer. It also comprises a MTJ conductive line 4edisposed on the magnetic tunnel junction 2 to flow the first write current I1 through the magnetic tunnel junction 2 while the first state is being written in the magnetic tunnel junction 2. The first write path therefore includes the first conductive line, the SOT current layer 3, the magnetic tunnel junction 2 and the MTJ conductive line. The first interface is a Peltier junction configured to generate heat while the first write current is flowing in the first write path. The interface between the MTJ conductive line and the magnetic tunnel junction is not configured to specifically generate or absorb heat, as it is the case for the first interface. The first interface being close to the free layer 2b of the magnetic tunnel junction 2, the temperature of this free layer 2b is increased while the first current I1 is flowing, and this helps the magnetization switching of this layer to store the first state.

This memory cell 1 also comprises a third conductive line 4c in electrical contact with the SOT current layer 3 at a third interface, at the other end of the SOT layer 3, the magnetic tunnel junction 2. A second write current I2 flows out of the SOT current layer 3 while the second state is being written in the magnetic tunnel junction 2. The second write path is distinct from the first write path and includes the MTJ conductive line 4e, the magnetic tunnel junction 2, the SOT current layer 3 and the first conductive line. The third interface is also a Peltier junction configured to generate heat while the second write current I2 is flowing in the second write path, increasing the temperature of free layer 2b of the magnetic tunnel junction 2.

Again, it is possible to take advantage of the ability to absorb heat at an interface during a read operation of a memory cell according to this sixth embodiment. This is achieved by configuring a read path including one of the conductive lines, and selecting the read current such that its direction is opposite to the write current direction at the level of the interface with the selected conductive line.

Other variations to the disclosed embodiments can be understood and effected by those skilled in the art in practicing the claimed invention, from a study of the drawings, the disclosure, and the appended claims.

In particular, and as it has already mentioned, all the presented embodiments and their variation may operate to absorb heat rather than generate heat when it was so described, and conversely to generate heat instead of absorbing it. This is generally obtained by reversing the direction of the read and write currents with respect to the direction described in those embodiments and in the figures.

The SOT current layer 3 may comprise a contact sublayer in contact with at least the first conductive line 4a, and possibly all other conductive lines contacting the SOT current layer. The contact sub layer of the SOT current layer 3 may be made of a conductive material selected for enhancing the Peltier effect at the interfaces with the conductive lines. The contact sub-layer is comprising for instance a semiconductor material or a metal. The SOT current layer in this configuration also comprises a SOT sublayer, on and in electrical contact with the contact sub layer. The magnetic tunnel junction 2 resides on this SOT sub layer. The write currents flow in both the contact sub layers and the SOT sub layers, such that the SOT effect on the magnetic tunnel junction is preserved, while the amount of heat generated at the interface is enhanced. Advantageously, the contact sub-layer is made of a material presenting high resistivity, at least twice or 5 time more than the SOT sublayer such that the current preferably flow with a higher density in the SOT sublayer rather than in the contact sub layer.

In all presented embodiments, the stack of layers may be reversed, i.e. by having the SOT current layer 3 on top of the magnetic tunnel junction, this junction being reversed such that the SOT current layer is contacting the free layer of this junction.

The memory device described in the various embodiment of this disclosure may be manufactured using conventional deposition steps and photolithographic steps to successively elaborate the various layers and patterns forming the stacks represented in the figures. The substrate onto which the stack of material is formed usually comprises part of the electronic circuits of and metallization's levels necessary to make the overall device functional. In particular the electronic circuit of the memory device is configured to activate the appropriate write/read path and to inject the appropriate current into the selected write/read path, such that an intended state is stored into the memory cell or read from the memory cell.

## Claims

1. A magneto resistive memory cell (1) comprising:
• a SOT current layer (3) defining a main plane;
• a magnetic tunnel junction (2) residing on the SOT current layer (3);
• a first conductive line (4a) in electrical contact with the SOT current layer (3) at a first interface to flow a first current (I, I1, R) into at least a portion of the SOT current layer (3), along a first path;
the magnetic memory cell (1) being **characterized in that** the first interface is a Peltier junction presenting a Peltier coefficient greater, in absolute value, than 30 mV to generate or absorb heat while the first current is flowing in the first path.

2. The magneto resistive memory cell (1) of claim 1 wherein the first conductive line (4a) is made of a p-type or a n-type semi-conductor material.

3. The magneto resistive memory cell (1) according to any of claims 1 to 2 wherein the first path comprises a first write path, the first write path comprising a second conductive line (4b) in electrical contact with the SOT current layer (3) at a second interface to flow a first write current (I, I1) in the SOT current layer (3) and store a first state in the magnetic tunnel junction (2).

4. The magneto resistive memory cell (1) of claim 3 wherein the first conductive line (4a) and the second conductive line (4b) are made of material presenting similar thermoelectric properties, and wherein the magnetic tunnel junction (2) is disposed on the SOT current layer (3) closer to the first interface than to the second interface.

5. The magneto resistive memory cell (1) of claim 4 further comprising a third conductive line (4c) in electrical contact with the SOT current layer (3) at a third interface to flow a second write current (12) along a second write path comprising the third conductive line (4c), the SOT current layer (3) and the second conductive line (4b) to store a second state into the magnetic tunnel junction (2).

6. The magneto resistive memory cell (1) of claim 3 wherein the first conductive line (4a) and the second conductive line (4b) are respectively made of semi-conductor materials of opposite doping type.

7. The magneto resistive memory cell (1) of claim 6 further comprising a third conductive line (4c) in electrical contact with the SOT current layer (3) at a third interface to flow a second write current (12) along a second write path comprising the third conductive line (4c), the SOT current layer (3) and the second conductive line (4b) to store a second state into the magnetic tunnel junction (2).

8. The magneto resistive memory cell (1) of claim 6 further comprising a third and fourth conductive lines (4c, 4d) in electrical contact with the SOT current layer (3) at respective third and fourth interfaces to flow a second write current (12) along a second write path comprising the third conductive line (4c), the SOT current layer (3) and the fourth conductive line (4d) to store a second state into the magnetic tunnel junction (2).

9. The magneto resistive memory cell (1) according to any of claims 3 to 8 further comprising a bias field (B) oriented in the main plane such that it presents a component along the write current direction(s).

10. The magneto resistive memory cell (1) according to any of claims 1 to 2 further comprising a MTJ conductive line disposed on the magnetic tunnel junction (2) to flow a first write current (I1) through the magnetic tunnel junction (2) while a first state is being written in the magnetic tunnel junction (2).

11. The magneto resistive memory cell (1) of claim 10 further comprising a third conductive line (4c) in electrical contact with the SOT current layer (3) at a third interface to flow a second write current (12) along a second write path comprising the MTJ conductive line (4b), the magnetic tunnel junction (2) and the SOT current layer (3) to store a second state into the magnetic tunnel junction (2).

12. The magneto resistive memory cell (1) according to any of claims 1 to 11 wherein the SOT current layer (3) comprises a contact sub-layer in electrical contact with the first conductive line (4a) and a SOT sub-layer over the contact sub-layer.

13. The magneto resistive memory cell (1) according to any preceding claims, wherein the first path comprises a first read path, the magneto resistive memory cell (1) being further configured to flow a read current (R) in the first read path comprising the magnetic tunnel junction (2) and the first interface.
